Europäisches Patentamt

European Patent Office

Office européen des brevets

(11) Veröffentlichungsnummer: **0 023 261**
**B1**

# EUROPÄISCHE PATENTSCHRIFT

(45) Veröffentlichungstag der Patentschrift:
**12.10.83**

(51) Int. Cl.³: **H 01 J 37/09**, H 01 J 37/147

(21) Anmeldenummer: **80103386.1**

(22) Anmeldetag: **18.06.80**

(54) Kompensierte magnetische Ablenkspule für Elektronenstrahl-Lithographiesysteme.

(30) Priorität: **30.07.79 US 61726**

(43) Veröffentlichungstag der Anmeldung:
**04.02.81 Patentblatt 81/5**

(45) Bekanntmachung des Hinweises auf die Patenterteilung:
**12.10.83 Patentblatt 83/41**

(84) Benannte Vertragsstaaten:
**DE FR GB**

(56) Entgegenhaltungen:
**US-A-3 173 116**
**US-A-3 911 321**
**US-A-3 984 687**
**US-A-4 125 772**

(73) Patentinhaber: **International Business Machines Corporation, Old Orchard Road, Armonk, N.Y. 10504 (US)**

(72) Erfinder: **Pfeiffer, Hans Christian, 25 Ketcham Road, Ridgefield, CO 06877 (US)**
Erfinder: **Sturans, Maris Andris, Cedar Hill Road, Rd No.1 Box 227, Bedford, NY 10506 (US)**

(74) Vertreter: **Schröder, Otto H., Dr.-Ing., c/o International Business Machines Corporation Zurich Patent Operations Säumerstrasse 4, CH-8803 Rüschlikon/ZH (CH)**

Kompensierte magnetische Ablenkspule für Elektronenstrahl-Lithographiesysteme

Die Erfindung betrifft eine kompensierte magnetische Ablenkspule für Elektronenstrahl-Lithographiesysteme mit einer Anzahl jeweils um zueinander senkrecht stehende Mittelebenen symmetrisch angeordneten toroidsektorförmigen Wicklungen mit innenliegenden und aussenliegenden Schenkeln, wobei die innenliegenden Schenkel der Wicklungen einen zylinderförmigen Raum für den Durchtritt des Elektronenstrahls bilden, der im wesentlichen parallel zur Achse dieses zylinderförmigen Raumes verläuft und der in Richtungen senkrecht zu dieser Achse durch magnetische Felder ablenkbar ist, die durch in den Wicklungen fliessende Ströme und durch Wirbelströme erzeugt werden.

Es ist allgemein bekannt, dass bestimmte magnetische Felder innerhalb von Elektronenstrahl-Systemen nachteilige Auswirkungen auf die Bewegung des Strahls in Zeit und Raum ausüben. Beispielsweise sind magnetische Ablenkfelder dynamischer Natur, d.h. für jede vorbestimmte Bewegung oder Ablenkung des Elektronenstrahls sind entsprechende Änderungen der die Ablenkspule ansteuernden Eingangssignale erforderlich. Die durch diese Ströme erzeugten Ablenkfelder erzeugen natürlich in jedem den Strahl umgebenden leitenden Material Wirbelströme. Diese Wirbelströme erzeugen wiederum unerwünschte Felder, die einen nachteiligen Einfluss auf die Bewegung des Strahls in Zeit und Raum vorzugsweise dadurch ausüben, dass sie den Strahl verzögern oder verlangsamen.

Da die Anforderungen an die Strahlbewegung in erfolgreich eingesetzten Elektronenstrahl-Lithographiesystemen eine aussergewöhnlich genaue und rasche magnetische Ablenkung des Elektronenstrahls nach vorbestimmten Orten auf einer Auftreffplatte erfodern, stellen diese Wirbelströme eine ganz wesentliche Schwierigkeit bei der Erzielung einer zufriedenstellenden Steuerung eines Elektronenstrahls dar.

In der DE-A-2 555 744 der Anmelderin ist ein Verfahren und eine Anordnung für die Verringerung von Wirbelströmen in magnetischen Ablenkspulen beschrieben. Diese Verringerung von Wirbelströmen wird dadurch erzielt, dass man die Polschuhe und die innenliegenden Teile der magnetischen Linse aus Ferrit und keramischen Materialien herstellt, die die Wirbelströme in diesen Teilen erheblich verringern, da die Leitfähigkeit der nichtleitenden Teile vernachlässigbar ist. Wenn man ausserdem das Ablenkjoch in der Mitte eines relativ grossen Linsenaufbaus anordnet, dann erstreckt sich das durch das Joch erzeugte Feld nicht wesentlich über die Polschuhe hinaus. Somit werden praktisch ausserhalb der Linse keine Wirbelströme erzeugt.

Es wurde jedoch festgestellt, dass mit der Verwendung von Elektronenstrahl-Systemen mit starken Ablenkfeldern und dementsprechend relativ grossen Ablenkspulen, die aus dicken Leitern bestehen, die nunmehr in den Windungen selbst erzeugten Wirbelströme nicht länger vernachlässigt werden können.

Obgleich eine ideale Lösung für solche Wirbelströme darin liegen könnte, diese intern erzeugten Ströme selbst zu unterdrücken, so wurde jedoch festgestellt, dass eine solche Lösung nur schwierig zu erzielen ist. Demgemäss besteht ein Bedarf dafür, die Auswirkungen von innerhalb der Windungen einer magnetischen Ablenkspule für ein Elektronenstrahl-System erzeugten Wirbelströmen zu unterdrücken.

Aus diesem Gedanken lässt sich dann eine Technik entwickeln, mit deren Hilfe rein theoretisch aus den Maxwell'schen Gleichungen die gewünschte Kompensation für eine solche Spule, in Abhängigkeit von der Wirbelstrom-Zeitkonstante eines gegebenen Ablenksystems, theoretisch vorhergesagt werden kann.

Aufgabe der Erfindung ist es, in einem Elektronenstrahl-Lithographiesystem eine Kompensation für die durch in den Windungen der magnetischen Ablenkspule auftretenden Wirbelströme hervorgerufenen Magnetfelder zu schaffen. Gleichzeitig soll damit erreicht werden, dass Ablenkfehler, die durch ein Nacheilen der Treiberstufen oder induktive bzw. kapazitive Kopplung innerhalb der Windungen der Spule auftreten, ebenfalls beseitigt werden.

Die Lösung der der Erfindung zugrundeliegende Aufgabe besteht also darin, dass zur Beseitigung unerwünschter Auswirkungen von Magnetfeldern, die durch die in den innen- und aussenliegenden Schenkeln der Wicklungen fliessenden Ablenkströme hervorgerufenen Wirbelströme erzeugt werden, passive Kompensationsmittel in Form von leitenden Blechen in der Nachbarschaft der aussenliegenden Schenkel der Wicklungen die Ablenkspule in Form von Zylindermantelflächensegmenten umgeben, deren Abmessungen und Lage so gewählt sind, dass die durch die in den Blechen selbst erzeugten Wirbelströme hervorgerufenen Magnetfelder die Wicklung der durch die in den innenliegenden Schenkeln fliessenden Wirbelströme hervorgerufenen Magnetfelder am Ort des Elektronenstrahls kompensieren, und dass dabei die Wirbelstrom-Zeitkonstante (T) der Bleche gleich der Wirbelstrom-Zeitkonstanten der Wicklungen ist.

Die Wirbelstrom-Zeitkonstante (T) des Kompensationsmaterials wird aus den Maxwell'schen Gleichungen abgeleitet, und die Abmessungen werden dann so gewählt, dass sich für alle Einschwingvorgänge eine räumlich und zeitlich optimale Kompensation ergibt. Die durch die vorherrschenden Wirbelströme in den Blechen erzeugten Felder kompensieren die in den innenliegenden Teilen der Spulen in der Nachbarschaft der Bahn des Elektronenstrahl erzeugten Wirbelströme und kompensieren damit die Ablenkspule für die Auswirkungen von Wirbelströmen.

Die Erfindung wird nunmehr anhand eines Ausführungsbeispiels in Verbindung mit den beigefügten Zeichnungen im einzelnen näher erläutert.

In den Zeichnungen zeigen

Fig. 1 eine schematische Ansicht eines Paars von Wicklungen einer toroidsektorförmigen Ablenkspule eines Elektronenstrahl-Systems,

Fig. 2 eine Draufsicht auf die in Fig. 1 dargestellte Ablenkspule, bei der die magnetischen Feldlinien gestrichelt eingezeichnet sind,

Fig. 3 eine perspektivische Ansicht einer gemäss der Erfindung ausgestalteten magnetischen Ablenkspule mit am äusseren Umfang der Ablenkspule vorgesehenen Blechen,

Fig. 4 eine Draufsicht auf einen vollständigen Satz von Wicklungen für die X-Ablenkung mit Darstellung der sich daraus ergebenden magnetischen Feldlinien und die Anordnung der der Kompensation dienenden Bleche,

Fig. 5 ein Diagramm zur Darstellung einer Gruppe von Zeitkonstanten-Lösungen für eine vorgegebene Geometrie, berechnet aus den Maxwell'schen Gleichungen,

Fig. 6 ein experimentelles Verfahren zum Messen der Auswirkungen von Wirbelströmen auf den Elektronenstrahl und

Fig. 7A-7C die Spuren eines Elektronenstrahls ohne Kompensation, mit Überkompensation bzw. richtiger Kompensation in einem Elektronenstrahl-System.

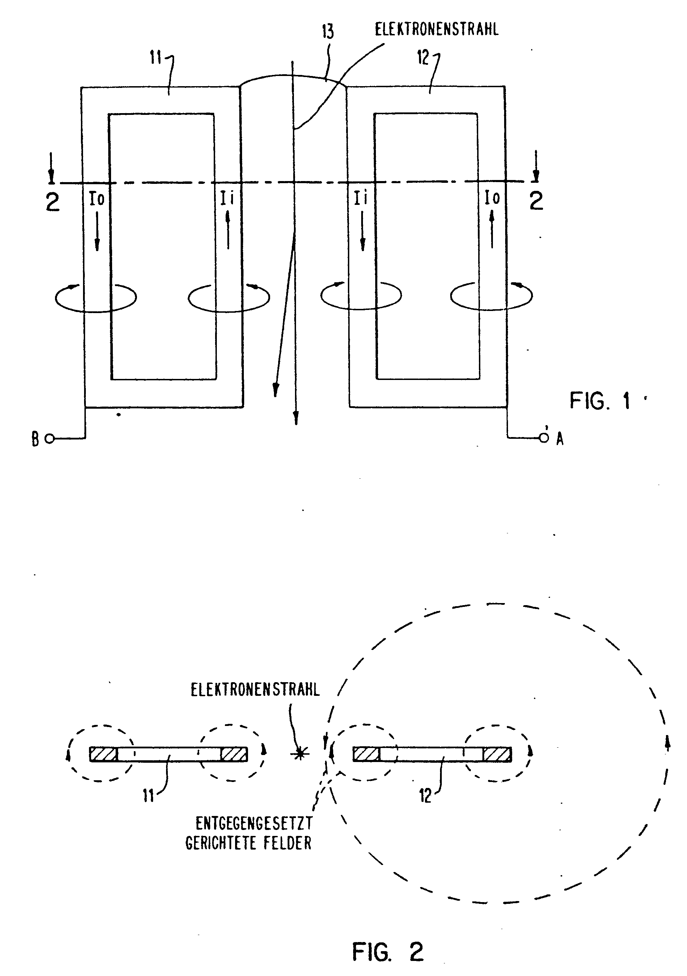

In Fig. 1 und 2 sind zwei Wicklungen oder ein Satz von Wicklungen einer magnetischen Ablenkspule dargestellt. Diese Wicklungen liegen normalerweise geometrisch einander gegenüber und steuern die Ablenkung eines Elektronenstrahls in der X- oder Y-Richtung. Selbstverständlich wäre eine zweite Gruppe von Wicklungen senkrecht zu den hier dargestellten Wicklungen angeordnet und würde damit die Ablenkung des Elektronenstrahls in der anderen Richtung steuern.

In der rechten Wicklung 12 ist ein Ablenkstrom $I_i$ mit der durch den Pfeil dargestellten Richtung gezeigt, der in dem inneren Schenkel der Wicklung fliesst. Dieser Strom erzeugt ein diesen Schenkel der Wicklung umgebendes Magnetfeld mit der durch den Pfeil angedeuteten Richtung. In gleicher Weise erzeugt der gleiche durch den äusseren Schenkel der Wicklung fliessende, mit $I_o$ bezeichnete Strom ein Feld, das gegenüber dem den innen liegenden Schenkel umgebenden Feld entgegengesetzt gerichtet ist. Dies ist am besten aus Fig. 2 zu erkennen. Da die Ströme $I_o$ und $I_i$ gleich gross sind und entgegengesetzt gerichtete Magnetfelder erzeugen, so könnte man annehmen, dass sich die Felder gegenseitig aufheben. Jedoch fliesst der Strom $I_i$ viel näher am Elektronenstrahl, so dass seine Wirkung auf den Strahl stärker ist. Der Ablenkstrom wird an den Klemmen A und B angelegt und fliesst über die Verbindungsleitung 13 in üblicher Weise.

Bekanntlich werden in leitendem Material bei Veränderung der Stromamplitude innerhalb der Spule Wirbelströme erzeugt, d.h. die Wirbelströme sind der Veränderung des Stromes mit der Zeit proportional. Da magnetische Ablenksignale entweder sägezahnförmige oder stufenförmige Signale sind, die jedesmal dann angelegt werden, wenn der Elektronenstrahl abgelenkt werden soll, treten auch die Wirbelströme innerhalb der Wicklungen der magnetischen Ablenkspule wiederholt auf.

Die Magnetfelder der durch den Strom $I_i$ erzeugten Wirbelströme sind der Strahlbewegung entgegengesetzt und verzögern die Ablenkbewegung des Strahls, während die Magnetfelder der durch den Strom $I_o$ erzeugten Wirbelströme die Strahlablenkung unterstützen. Die gesamte Stärke des durch $I_i$ und $I_o$ in dem Material der Wicklung erzeugten Wirbelstroms kann als Äquivalent betrachtet werden, wobei jedoch die unmittelbare Nachbarschaft des Strahls zu dem Strom $I_i$ eine wesentlich stärkere Einwirkung des auf $I_i$ zurückgehenden Wirbelstromes zur Folge hat. Das hat wiederum zur Folge, dass als Resultat bei Ablenkung des Elektronenstrahls die Ablenkbewegung des Strahls verlangsamt wird. Es ist daher notwendig, die Auswirkung des durch den im äusseren Schenkel der Wicklung fliessenden Strom $I_o$ hervorgerufenen Wirbelstroms zu erhöhen, um damit die Verzögerungswirkung des innen liegenden Schenkels der Wicklung zu kompensieren. Dies kann dadurch erreicht werden, dass man gemäss der Erfindung in der Nachbarschaft des Stromes $I_o$ mehr leitendes Material anbringt.

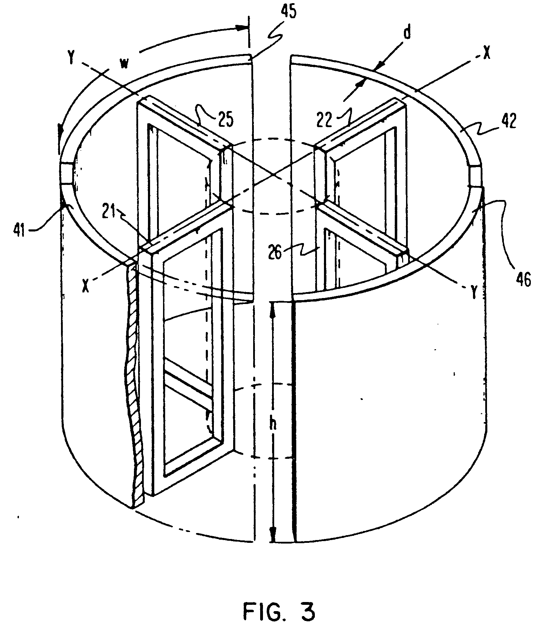

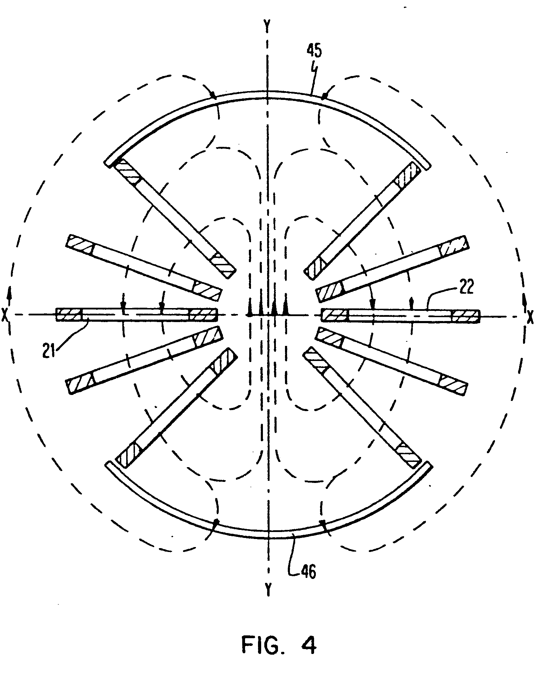

Die Art der Kompensation und wie sie durchgeführt werden soll wird nunmehr im einzelnen im Zusammenhang mit Fig. 3 und 4 beschrieben. In Fig. 3 ist rein schematisch eine kompensierte, magnetische Ablenkspule dargestellt. Die Spule besteht dabei aus den Wicklungen 21, 22, die die Ablenkung des Strahls in einer Richtung steuern und den senkrecht dazu angeordneten Wicklungen 25 und 26, die die Ablenkung des Elektronenstrahls in einer dazu senkrecht verlaufenden Richtung steuert. Die Ablenkströme werden bei den hier nicht gezeigten Eingangsklemmen gemäss Fig. 1 zugeführt.

Es sei darauf hingewiesen, dass jeder Satz von Wicklungen um einen nicht dargestellten, nichtleitenden Kern herum angeordnet ist. Es sei ferner daran erinnert, dass für jede der Ablenkrichtungen X und Y in Fig. 3 nur ein Paar Wicklungen dargestellt ist. In Wirklichkeit ist die Konstruktion so aufgebaut, dass die magnetische Ablenkspule aus 5 Wicklungspaaren für die X-Richtung gemäss Fig. 4 und einer identischen Anordnung von 5 Wicklungspaaren für die Y-Richtung besteht. In der bevorzugten Ausführungsform bestehen die Wicklungen aus mehreren Windungen Kupferdraht, d.h. 25 Windungen je Wicklung aus Reinstkupferdraht. Die Spule ist ungefähr 5 cm hoch, hat einen äusseren Durchmesser von 12 cm und einen inneren Durchmesser von 3 cm und ist innerhalb des Elektronenstrahl-Systems, die Bahn des Elektronenstrahls innerhalb einer Projectionslinse umgebend angeordnet, wie dies in der DE-OS-2 555 744 beschrieben ist.

Die der Kompensation dienenden Bleche 41, 42 sind ausserhalb der Wicklungen 21, 22 dargestellt, während die der Kompensation dienenden Bleche 45, 46 ausserhalb der Wicklungen 25 bzw. 26 dargestellt sind.

In Fig. 4 sind die der Kompensation dienenden Bleche 45 und 46 gezeigt, um darzulegen, dass diese der Kompensation dienenden Bleche für eine gegebene Wicklung in einer gekrümmten Fläche angeordnet sind, deren Mittellinie auf einer Achse Y liegt, die senkrecht auf der Ablenkrichtung X steht, d.h. die der Kompensation dienenden Bleche 45 und 46 sollen dabei die durch die Wicklungen 21 bzw. 22 hervorgerufenen Wirbelströme kompensieren. Somit sind also die der Kompensation dienenden Bleche in geringerem Abstand von dem äusseren Schenkel der Wicklungen 21 und 22 als von den inneren Schenkeln dieser Wicklungen angeordnet. Es sei ferner darauf hingewiesen, dass die Stärke der Wirbelströme in den Blechen um so mehr zunimmt, je mehr sich die Richtung des auffallenden Magnetfeldes 90° nähert, d.h. die äusseren Schenkel der Wicklungen haben einen stärkeren Einfluss. Dies hat zur Folge, dass die durch die äusseren Schenkel der Wicklungen in den Blechen erzeugten Wirbelströme stärker sind, als die in den Blechen durch die inneren Schenkel der Wicklungen erzeugten Wirbelströme. Somit sind auch die entgegengerichteten Felder, die die Strahlablenkung unterstützen, und die durch die der Kompensation dienenden Bleche erzeugten Wirbelströme hervorgerufen sind, stärker und räumen damit die Auswirkungen der im innen liegenden Schenkel der Wicklungen auf die Bahn des Elektronenstrahls ausgeübten Wirkungen aus. Es sei ferner darauf hingewiesen, dass die Bahn des Elektronenstrahls (die Bahn der geladenen Teilchen) in Fig. 4 im wesentlichen senkrecht auf der Ablenkrichtung X und der Ablenkrichtung Y steht und innerhalb des zylindrischen Raums verläuft, der durch die inneren Schenkel der Wicklungen 21 und 22 definiert ist.

Durch richtige Wahl der Abmessungen der Bleche kann man für eine Spule mit einer vorgegebenen Wirbelstrom-Zeitkonstante die richtige Kompensation erreichen, wenn man die Wirbelstrom-Zeitkonstante der Bleche gleich gross macht.

Gemäss der Lösung der Maxwell'schen Gleichung ist die Wirbelstrom-Zeitkonstante T des elektrisch leitenden Bleches gleich:

$$T = \frac{\sigma \mu_0}{\dfrac{1}{\eta^2} \left( \dfrac{1}{w^2} + \dfrac{1}{h^2} + K \delta d \right)}$$

wobei

$\delta$ = Eindringtiefe = $\sqrt{\dfrac{2}{\sigma \omega \mu_0}}$

w = Breite
h = Höhe
d = Dicke
$\sigma$ = Leitfähigkeit
$\mu_0$ = Permeabilität
$\omega$ = Kreisfrequenz
K = Konstante = 1350 (empirisch ermittelt)
$\pi$ = Konstante

sind.

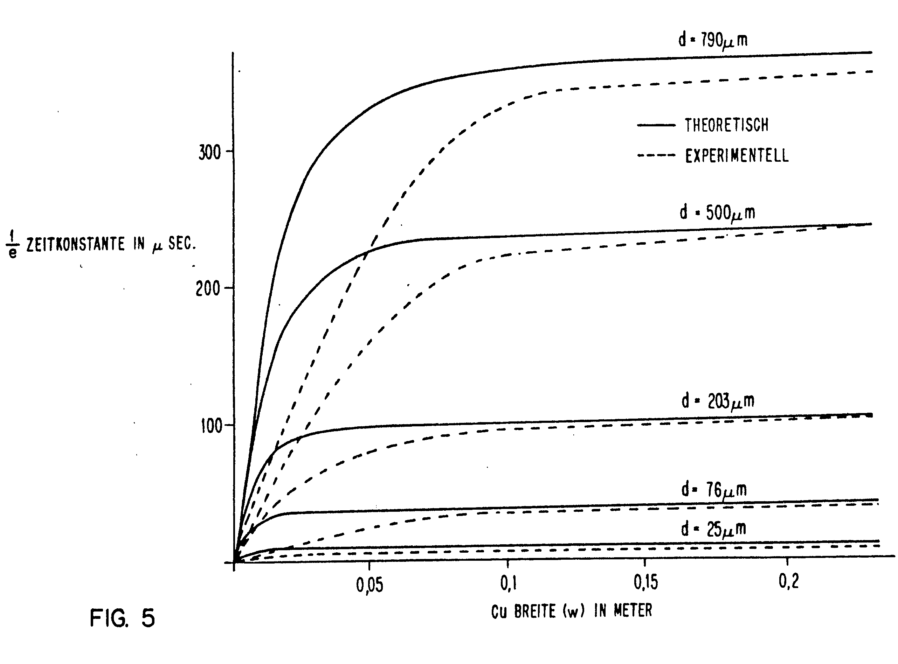

Fig. 5 zeigt eine Kurvenschar zur Darstellung der theoretisch berechneten und experimentell ermittelten Wirbelstrom-Zeitkonstanten eines aus Kupfer bestehenden Bleches mit einer der Höhe der Ablenkspule entsprechenden Höhe. Insbesondere ist die Höhe für das der Kompensation dienende Blech 4,96 cm, und es wurden verschiedene Dicken und Breiten des Bleches untersucht und sind in der hier dargestellten Kurvenschar mit 4 Kurven gezeigt. Somit können die in Fig. 5 dargestellten Kurven zur Bestimmung der idealen Dicke und Breite eines der Kompensation dienenden Bleches mit einer von 4,96 cm für eine Ablenkspule benutzt werden, sobald die $\dfrac{1}{e}$ Wirbelstrom-Zeitkonstante in Mikrosekunden für diese Spule gemessen ist. Es sollte somit klar sein, dass eine Spule mit eine Wirbelstrom-Zeitkonstante von 200 Mikrosekunden durch ein Blech mit einer Dicke von etwa 500 $\mu$m und einer Breite von mehr als 0,05 m kompensiert werden kann. Eine weitere Vergrösserung in der Breite ändert nur die Amplitude des Wirbelstroms, nicht jedoch seine Zeitkonstante.

In gleicher Weise sollte klar sein, dass eine Spule mit einer Wirbelstrom-Zeitkonstante von etwa 100 Mikrosekunden mit Hilfe eines Bleches mit einer Dicke von 203 $\mu$m und einer Breite von mehr als 0,05 m kompensiert werden kann. In der bevorzugten Ausführungsform wurde mit einer Zeitkonstante der Spule von 35 Mikrosekunden eine volle Kompensation mit einem Blech mit einer Dicke von 76 $\mu$m und einer Breite von mehr als 0,05 m erreicht.

Der Unterschied zwischen theoretischen und experimentell ermittelten Ergebnissen in Fig. 5 lässt sich auf die Tatsache zurückführen, dass die Berechnung auf einem Kupferblech mit ebenen Abmessungen basiert, während das Experiment aus praktischen Gründen mit einem Blech durchgeführt wurde, das um eine Prüfspule mit kleinem Durchmesser herumgelegt war. Da das Hauptinteresse auf eine asymptotische Zeitkonstante (w > h) gerichtet ist, wurde diese Winkelabhängigkeit bei der Annäherung weggelassen.

Eine zweite Wirkung, die ausser den Wirbelströmen eine Verzögerung der Strahlablenkung bewirkt, wird durch die Einstellzeit der Treiberschaltung verursacht, welche eine Funktion der Spuleninduktivität ist. Es sollte klar sein, dass dann, wenn diese gesamte Einschwingzeit des Strahls gemessen wurde (Wirbelstrom plus Treiberstrom plus induktive oder kapazitive Kopplung), dass dann für vollständige Kompensation die genauen Abmessungen des Bleches festgelegt werden können.

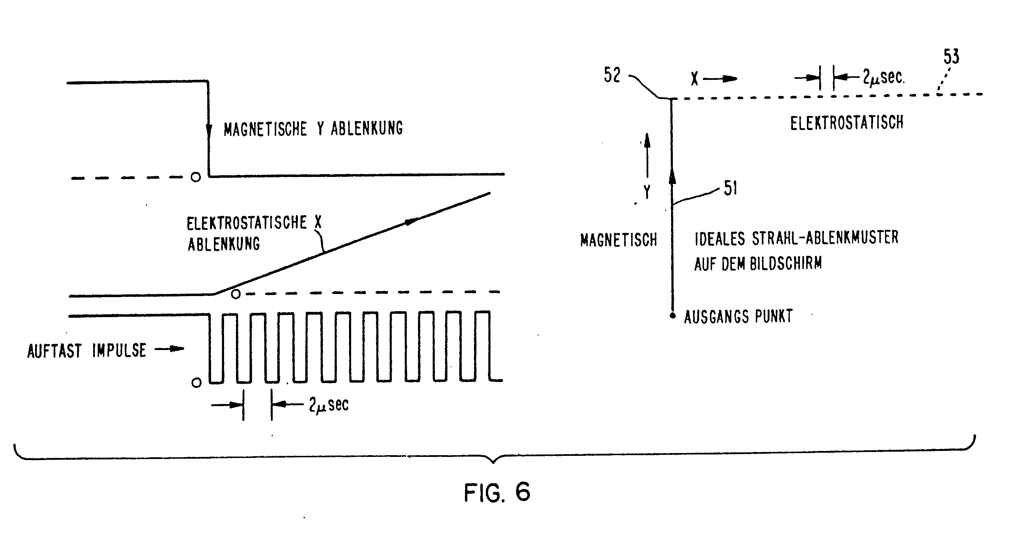

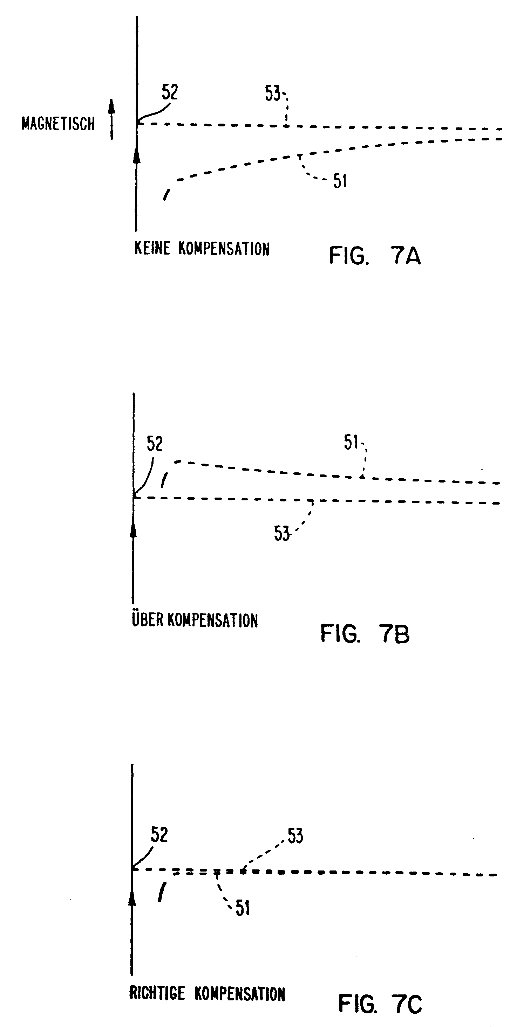

Fig. 6 zeigt das experimentelle Verfahren für die Messung der Einschwingzeit des Elektronenstrahls und der Wirksamkeit des hier beschriebenen Kompensationsverfahrens. Im Idealfall würde die magnetische Ablenkung 51 längs einer Linie verlaufen, die senkrecht auf der elektrostatischen Ablenkspur 53 verläuft und augenblicklich auf dem Auftreffpunkt 52 auftreffen. Die tatsächlichen vom Elektronenstrahl durchlaufenen Spuren sind für verschiedene Arten der Kompensation in Fig. 7 gezeigt. Es sei darauf verwiesen, dass als Bezugspunkt der ideale Verlauf in jedem Fall eingezeichnet ist, den man durch Einstellung der magnetischen Ablenkung auf Null erhält. Fig. 7A zeigt dabei die Verzögerung des Elektronenstrahls durch die Ablenkspule ohne Kompensation. Bringt man zu viel Kompensationsmaterial um die Spule herum an, dann kann die entgegengesetzte Wirkung erzielt werden, wie dies Fig. 7B zeigt, wobei der Strahl bei Ablenkung über die Linie 53 hinaus abgelenkt wird und dann allmählich zu einem späteren Zeitpunkt sich im eingeschwungenen Zustand der Linie 53 nähert. Bei richtiger Kompensation, Fig. 7C, wird der Strahl in die unmittelbare Nähe des Punktes 52 abgelenkt und nach einer ganz kurzen Zeit vereinigen sich die Spuren 53 (ideal) und 51 (tatsächlich).

Die hier beschriebene Technik macht es möglich, dass eine magnetische Ablenkspule mit einem der Kompensation dienenden Kupferblech versehen wird, das am Umfang der Spule mit ziemlich hoher Präzision angeordnet wird und damit bisher nicht kompensierte Auswirkungen von Wirbelströmen beseitigt. Mit zunehmenden Abmessungen magnetischer Ablenkspulen mit Kupferdraht von immer grösserem Durchmesser haben solche Wirbelströme zunehmend nachteilige Auswirkungen auf die Ablenkung des Elektronenstrahls. Gleichzeitig haben die zunehmend schwierig zu erfüllenden Anforderungen bei der Elektronenstrahl-Lithographie in der Herstellung von Halbleiterschaltungen unter Verwendung von Elektronenstrahl-Systemen eine immer höhere Genauigkeit bei der Anlenkung zwingend erforderlich gemacht.

Demgemäss hat die vorliegende Erfindung eine beträchtliche Verbesserung bei den Möglichkeiten von Elektronenstrahl-Systemen bei der Erfüllung der Erfordernisse für mikrophotolithographische Herstellungsverfahren erbracht.

## Patentansprüche

1. Kompensierte magnetische Ablenkspule für Elektronenstrahl-Lithographiesysteme mit einer Anzahl jeweils um zueinander senkrecht stehende Mittelebenen symmetrisch angeordneten toroidsektorförmigen Wicklungen (21, 22, 25, 26) mit innenliegenden und aussenliegenden Schenkeln, wobei die innenliegenden Schenkel der Wicklungen einen zylinderförmigen Raum für den Durchtritt des Elektronenstrahls bilden, der im wesentlichen parallel zur Achse dieses zylinderförmigen Raumes verläuft und der in Richtungen senkrecht zu dieser Achse durch magnetische Felder ablenkbar ist, die durch in den Wicklungen fliessende Ströme und durch Wirbelströme erzeugt werden, dadurch gekennzeichnet, dass zur Beseitigung unerwünschter Auswirkungen von Magnetfeldern, die durch die in den innen- und aussenliegenden Schenkeln der Wicklungen (21, 22, 25, 26) fliessenden Ablenkströme hervorgerufenen Wirbelströme erzeugt werden, passive Kompensationsmittel in Form von leitenden Blechen (41, 42, 45, 46) in der Nachbarschaft der aussenliegenden Schenkel der Wicklungen die Ablenkspule in Form von Zylindermantelflächensegmenten umgeben, deren Abmessungen und Lage so gewählt sind, dass die durch die in den Blechen selbst erzeugten Wirbelströme hervorgerufenen Magnetfelder zusammen mit den durch die in den aussenliegenden Schenkeln fliessenden Wirbelströme hervorgerufenen Magnetfelder die Wirkung der durch die in den innenliegenden Schenkeln fliessenden Wirbelströme hervorgerufenen Magnetfelder am Ort des Elektronenstrahls kompensieren, und dass dabei die Wirbelstrom-Zeitkonstante (T) der Belche gleich der Wirbelstrom-Zeitkonstanten der Wicklungen ist.

2. Ablenkspule nach Anspruch 1, dadurch gekennzeichnet, dass die Achse des Zylinders, auf dessen Mantelfläche die Bleche (41, 42, 45, 46) angeordnet sind, auf einer zur jeweiligen Ablenkrichtung senkrecht stehenden Achse liegt und dass damit die durch die aussenliegenden Schenkel der Wicklungen erzeugten Feldlinien etwa senkrecht zur Zylindermantelfläche auftreffen.

## Revendications

1. Bobine à déflexion magnétique compensée conçue pour des systèmes de lithographie par faisceaux électroniques, qui comporte plusieurs enroulements toroïdaux (21, 22, 25, 26) disposés chaque fois symétriquement par rapport à des plans médians perpendiculaires les uns par rapport aux autres, lesquels enroulements sont dotés de bras intérieurs et extérieurs, lesdits bras intérieurs formant un espace cylindrique pour recevoir le faisceau électronique qui est, en général, diffusé de façon parallèle à l'axe dudit espace cylindrique et qui peut être dévié dans des directions perpendiculaires à cet axe, sous l'influence de champs magnétiques générés par les courants qui circulent dans lesdits enroulements et par des courants de Foucault, caractérisée en ce que, pour éliminer les effets indésirés desdits champs magnétiques qui sont dûs aux courants de Foucault, générés par les courant de déflexion qui circulent à travers les bras intérieurs et extérieurs, desdits enroulements (21, 22, 25, 26), il est prévu des moyens de compensation passifs représentés par des plaques conductrices (41, 42, 45, 46), situées à proximité des bras extérieurs desdits enroulements, qui entourent ladite bobine de déflexion sous la forme de segments de revêtement cylindriques, dont les dimensions et l'emplacement sont définis de sorte que les champs magnétiques dûs aux courants de Foucalts, eux-mêmes générés dans lesdites plaques associés aux champs magnétiques dûs aux courants de Foucault qui circulent à travers lesdits bras extérieurs compensent les effets des champs magnétiques, dûs aux courants de Foucault qui circulent à travers lesdits bras intérieurs, sur le faisceau électronique, et en ce que la constante de temps du courant de Foucault (T) dans lesdites plaques conductrices est égale à la constante de temps du courant de Foucault dans lesdits enroulements.

2. Bobine compensée selon la revendication 1, caractérisé en ce que l'axe du cylindre, sur la surface duquel sont disposées lesdites plaques (41, 42, 45, 46) et disposé selon un axe perpendiculaire à la direction de déflection respective, et en ce que les lignes de champ produites par les bras extérieurs desdits enroulements frappent la surface de revêtement dudit cylindre de façon presque perpendiculaire.

## Claims

1. Compensated magnetic deflection coil for electron beam lithographic systems with a plurality of toroidal windings (21, 22, 25, 26) respectively symmetrically arranged round vertical central planes, with inner and outer arms, the inner arms of the windings defining a cylindrical space for passing the electron beam substantially parallel to the axis of this cylindrical space, and which is deflectable in directions perpendicular to this axis by magnetic fields generated by currents flowing through the windings, and by eddy currents, characterized in that for eliminating undesired effects of magnetic fields which are generated by eddy currents caused by deflection currents flowing in the inner and outer arms of the windings (21, 22, 25, 26), passive compensating means in the form of conductive sheets (41, 42, 45, 46) close to the outer arms of the windings surround the deflection coil in the form of cylindrical segments whose dimensions and position are selected in such a manner that the magnetic fields caused by the eddy currents generated in the sheets themselves, together with the magnetic fields caused by the eddy currents in the outer arms compensate the effect of the magnetic fields caused by the eddy currents in the inner arms, at the place of the electron beam, and that the eddy current time constant (T) of the sheets equals the eddy current time constants of the windings.

2. Deflection coil as claimed in claim 1, characterised in that the axis of the cylinder on whose generated surface the sheets (41, 42, 45, 46) are located is positioned on an axis orthogonal to the respective direction of deflection, and that thus the field lines generated by the outer arms of the windings impinge approximately vertically to the generated surface of the cylinder.

ELEKTRONENSTRAHL

13

11    12

2    2

$I_0$    $I_i$    $I_i$    $I_0$

FIG. 1

B    A

ELEKTRONENSTRAHL

11    12

ENTGEGENGESETZT
GERICHTETE FELDER

FIG. 2

FIG. 3

FIG. 4

FIG. 5

MAGNETISCHE Y ABLENKUNG

ELEKTROSTATISCHE X ABLENKUNG

AUFTAST IMPULSE →

2μsec

52

X →

2μsec.

53

ELEKTROSTATISCH

Y

51

MAGNETISCH

IDEALES STRAHL-ABLENKMUSTER AUF DEM BILDSCHIRM

AUSGANGS PUNKT

FIG. 6

0 023 261

MAGNETISCH ↑

52    53    51

KEINE KOMPENSATION    FIG. 7A

52    51    53

ÜBER KOMPENSATION    FIG. 7B

52    53    51

RICHTIGE KOMPENSATION    FIG. 7C